# EUROPEAN PATENT APPLICATION

(11) **EP 2 287 370 A1**
(43) Date of publication of application: **23.02.2011**
(21) Application number: 09754637.8
(22) Date of filing: 25.05.2009
(51) Int. Cl.: C30B 29/38, H01L 21/3065, H05H 1/46

(54) **A l X G a 1-X N SINGLE CRYSTAL AND ELECTROMAGNETIC WAVE TRANSMISSION BODY**

(30) Priority: 28.05.2008 JP 2008139860; 10.02.2009 JP 2009028839
(71) Applicant: Sumitomo Electric Industries, Ltd., Chuo-ku Osaka-shi Osaka 541-0041 (JP)
(72) Inventor: ARAKAWA, Satoshi, Itami-shi Hyogo 664-0016 (JP); SAKURADA, Takashi, Itami-shi Hyogo 664-0016 (JP); MIYANAGA, Michimasa, Osaka-shi Osaka 554-0024 (JP); TANIZAKI, Keisuke, Itami-shi Hyogo 664-0016 (JP); MIZUHARA, Naho, Itami-shi Hyogo 664-0016 (JP); SATOH, Issei, Itami-shi Hyogo 664-0016 (JP); NAKAHATA, Hideaki, Itami-shi Hyogo 664-0016 (JP)
(74) Representative: Grünecker, Kinkeldey, Stockmair & Schwanhäusser Anwaltssozietät
(86) International application number: PCT/JP2009/059501
(87) International publication number: WO 2009/145129

(57) **Abstract**

Affords an Al*ₓ*Ga_{1-*x*}N single crystal suitable as an electromagnetic wave transmission body, and an electromagnetic wave transmission body that includes the Al*ₓ*Ga_{1-*x*}N single crystals.

The Al*ₓ*Ga_{1-*x*}N (0 < x ≤1) single crystal (2) has a dielectric loss tangent of 5 × 10⁻³ or lower with a radio frequency signal of at least either 1 MHz or 1 GHz having been applied to the crystal at an atmospheric temperature of 25°C. An electromagnetic wave transmission body (4) includes the Al*ₓ*Ga_{1-*x*}N single crystal, which has a major surface (2*m*), wherein the Al*ₓ*Ga_{1-*x*}N single crystal (2) has a dielectric loss tangent of 5 × 10⁻³ or lower with an RF signal of at least either 1 MHz or 1 GHz having been applied thereto at an atmospheric temperature of 25°C.

## Description

### Technical Field

The present invention relates to Al*ₓ*Ga₁₋ₓN (0 < x ≤ 1) single crystals and electromagnetic wave transmission bodies containing Al*ₓ*Ga_{1*-x*}N single crystals, suitably utilized in electronic components, microelectronic components, optoelectronic components, and like applications.

### Background Art

In plasma generation apparatuses, which apply radio-frequency power to gases to create plasmas, materials such as quartz glass are employed as an electromagnetic wave transmission body. When exposed to a plasma of non-corrosive gases such as Ar, N₂, O₂ or SiH₄, such electromagnetic wave transmission bodies emit heat owing, in addition to absorption of the high-frequency energy, to ion bombardment and radiant heat from the plasma, therefore making necessary heat-emission prevention and heat-shock resistance in electromagnetic wave transmission bodies. And when quartz glass as an electromagnetic wave transmission body is exposed to plasma from chlorine- or fluorine-containing corrosive gases corrosive gases such as C1F₃, NF₃, CF₄, CHF₃, and SiH₂Cl₂ for example-a difficulty arises in that the material is etched at a high rate and Si and O, etching by-products from the quartz, mix into the plasma.

Alumina (aluminum oxide) is effective from the standpoint of resistance to corrosive gases. However, because alumina has poor resistance to heat shock and has a low thermal conductivity, there is the problem of the temperature becoming locally high with a high-power plasma, and thermal stress causing breakage.

With respect to a high-power plasma, an aluminum nitride sintered ceramic having a high thermal conductivity and a low thermal expansion coefficient has a high resistance to corrosive halogen-based gases, and is preferable to alumina (cf., for example, Japanese Unexamined Pat. App. Pub. H07-142197 (Patent Document 1) and Japanese Unexamined Pat. App. Pub. H07-142414 (Patent Document 2)). However, even a sintered aluminum nitride electromagnetic wave transmission body, when exposed to a high-power plasma, exhibits variations in dielectric properties between lots, thereby hindering the reproducibility of transmission characteristics.

For this reason, there has been a need for a high-quality electromagnetic wave transmission body having a small (dielectric) dielectric loss tangent so as to suppress heat generation, particularly with respect to high-frequency electromagnetic radiation. In order to solve these problems, control of the silicon concentration in the sinter (cf., for example, Japanese Unexamined Pat. App. Pub. No. 2000-335974 (Patent Document 3)), refinements in the plasma processing and suppression of the dipole density and activation thereof caused by defects in the crystal phase, which causes absorption of electromagnetic radiation (cf., for example, to Japanese Unexamined Pat. App. Pub. No. 2002-172322 (Patent Document 4)), and addition to the aluminum nitride of yttrium oxide and magnesium oxide or magnesium nitride (refer to, for example, Japanese Unexamined Pat. App. Pub. No. 2006-08493 (Patent Document 5)) have been done.

### Citation List

### Patent Literature

Patent Document 1: Japanese Unexamined Pat. App. Pub. No. H07-142197
Patent Document 2: Japanese Unexamined Pat. App. Pub. No. H07-142414
Patent Document 3: Japanese Unexamined Pat. App. Pub. No. 2000-335974
Patent Document 4: Japanese Unexamined Pat. App. Pub. No. 2002-172322
Patent Document 5: Japanese Unexamined Pat. App. Pub. No. 2006-008493

### Summary of Invention

### Technical Problem

However, an aluminum nitride sinter has many crystal grain boundaries and often contains a sintering additive. For this reason, because an aluminum nitride sinter has low thermal conductivity compared to an aluminum nitride single crystal and the coefficient of thermal expansion thereof exhibits local variations, there is a limitation to the increase in resistance to heat shock.

Compared to aluminum nitride single crystals, an aluminum nitride sinter has many crystal defects, and because a sintering aide such as Al₂O₃, Y₂O₅, CaO, or MgO is used as a source material, the oxygen concentration is high. For this reason, an aluminum nitride sinter has a high dielectric loss tangent, and there is the problem that when high-power RF electrical power is applied, the temperature increases sharply and the dielectric properties change.

Additionally, it is difficult to achieve planarity of the surface because loosening of crystal grains occurs when the surface of an aluminum nitride sinter is polished.

Accordingly, an object of the present invention is to solve the above-noted problems and to make available an Al*ₓ*Ga_{1-*x*}N single crystal suitable as an electromagnetic wave transmission body and an electromagnetic wave transmission body that includes the Al*ₓ*Ga_{1-*x*}N single crystal.

### Solution to Problem

The present invention is an Al*ₓ*Ga_{1-*x*}N (0 < x ≤ 1) single crystal having a dielectric loss tangent of 5 × 10⁻³ or lower when an RF signal of at least either 1 MHz or 1 GHz is applied to the crystal at an atmospheric temperature of 25°C.

The Al*ₓ*Ga_{1-*x*}N single crystal of the present invention can be made to have a dielectric loss tangent of 5 × 10⁻³ or lower with a 1-MHz RF signal applied thereto and also made to have a dielectric loss tangent of 5 × 10⁻³ or lower with a 1-GHz RF signal applied thereto. Also, the oxygen concentration of the Al*ₓ*Ga_{1-*x*}N single crystal of the present invention can be made 1 × 10¹⁸ cm⁻³ or lower. And the dislocation density of the Al*ₓ*Ga_{1-*x*}N single crystal of the present invention can be made 1 × 10⁶ cm⁻² or lower. The span or diameter of the Al*ₓ*Ga_{1-*x*}N single crystal of the present invention can be made 10 mm or greater and the thickness thereof can be made 300 µm or lower. The RMS surface roughness of the Al*ₓ*Ga_{1-*x*}N single crystal can be made 100 nm or lower.

Also, the present invention is an electromagnetic wave transmission body that includes an Al*ₓ*Ga_{1-*x*}N (0 < *x* ≤ 1) single crystal having a major plane, wherein the dielectric loss tangent of the Al*ₓ*Ga_{1-*x*}N single crystal is 5 × 10⁻³ or lower with at least either a 1-MHz RF signal or a 1-GHz RF signal having been applied thereto at an atmospheric temperature of 25°C.

In the electromagnetic wave transmission body of the present invention, the Al*ₓ*Ga_{1-*x*}N single crystal can be made to have a dielectric loss tangent of 5 × 10⁻³ or lower with a 1-MHz RF signal having been applied thereto and also to have a dielectric loss tangent of 5 × 10⁻³ or lower with a 1-GHz RF signal having been applied thereto. Also, the oxygen concentration of the Al*ₓ*Ga_{1-*x*}N single crystal of the present invention can be made 1 × 10¹⁸ cm⁻³ or lower. And the dislocation density of the Al*ₓ*Ga_{1-*x*}N single crystal of the present invention can be made 1 × 10⁶ cm⁻² or lower. The span or diameter of the Al*ₓ*Ga_{1-*x*}N single crystal of the present invention can be made 10 mm or greater, and the thickness thereof can be made 300 µm or greater. The RMS surface roughness of the Al*ₓ*Ga_{1-*x*}N single crystal can be made 100 nm or lower.

### Advantageous Effects of Invention

The present invention make available an Al*ₓ*Ga_{1-*x*}N single crystal preferable as an electromagnetic wave transmission body, as well as an electromagnetic wave transmission body that includes the Al*ₓ*Ga_{1-*x*}N single crystal.

### Brief Description of Drawings

Fig. 1 is a simplified cross-sectional view showing an example of an apparatus and a method for manufacturing an Al*ₓ*Ga_{1-*x*}N single crystal of the present invention.
Fig. 2 is two simplified cross-sectional views showing examples of an electromagnetic wave transmission body of the present invention, wherein (A) shows an example in which the entire electromagnetic wave transmission body is a Al*ₓ*Ga_{1-*x*}N single crystal, and (B) shows an example in which a part of the electromagnetic wave transmission body is a Al*ₓ*Ga_{1-*x*}N single crystal.
Fig. 3 is a simplified cross-sectional view showing an example of a method of measuring the dielectric constant and the dielectric loss tangent of an electromagnetic wave transmission body of the present invention.
Fig. 4 is a simplified cross-sectional view showing another example a method of measuring the dielectric constant and the dielectric loss tangent of an electromagnetic wave transmission body of the present invention.

### Description of Embodiments

### AlₓGa₁₋ₓN Single Crystal

Compared to an AIN (aluminum nitride) sinter, the Al*ₓ*Ga_{1-*x*}N single crystal that is the first embodying mode of the present invention has a high thermal conductivity, and little local variation in the coefficient of thermal expansion. For this reason, even if exposed to a high-frequency plasma, the Al*ₓ*Ga_{1-*x*}N single crystal tends to be immune to thermal stress and has a high resistance to heat shock. Also, because the Al*ₓ*Ga_{1-*x*}N single crystal of this embodying mode has a dielectric loss tangent of 5 × 10⁻³ or lower when at least either a 1-MHz RF signal or a 1-GHz RF signal is applied thereto at an atmospheric temperature of 25°C, even if high-frequency electromagnetic radiation is transmitted, the dielectric losses are extremely small, making it suitable as an electromagnetic wave transmission body.

It is preferable that, at an atmospheric temperature of 25°C, the Al*ₓ*Ga_{1-*x*}N single crystal of this embodying mode have a dielectric loss tangent of 5 × 10⁻³ or lower when a 1-MHz RF signal is applied thereto and also a dielectric loss tangent of 5 × 10⁻³ or lower when a 1-GHz RF signal is applied thereto. The Al*ₓ*Ga_{1-*x*}N single crystal has an extremely low dielectric loss even when transmitting electromagnetic radiation over a broad range of high frequencies spanning from the order of MHz to the order of GHz, and is preferably used as an electromagnetic wave transmission body.

According to the knowledge of the inventors, oxygen atoms included in an Al*ₓ*Ga_{1-*x*}N single crystal are replaced by nitrogen atoms (replacement oxygen atom ON), and also bond to lattice defects (vacancy V_{Al}) in the aluminum, so as to form a complex defect V_{Al}-O_{N}). It is thought that the dielectric loss tangent becomes large by this complex defect V_{Al}-O_{N} forming a dipole.

From the standpoint of making the oxygen concentration small and suppressing the formation of the complex defect V_{Al}-O_{N} to make the dielectric loss tangent small, therefore, the Al*ₓ*Ga_{1-*x*}N single crystal of this embodying mode, although it is not particularly limited in this regard, has an oxygen concentration that is preferably 1 × 10¹⁸ cm⁻³ or lower, and more preferably 3 × 10¹⁷ cm⁻³ or lower.

From the standpoint of keeping complex defects V_{Al}-O_{N} from forming, the Al*ₓ*Ga_{1-*x*}N single crystal of this embodying mode, although not particularly limited in this regard, has a dislocation density that is preferably 1 × 10⁶ cm⁻² or lower and more preferably 5 × 10⁵ cm⁻² or lower, and yet more preferably 1 × 10⁵ cm⁻² or lower.

Also, from the standpoint of having a size and mechanical strength that are preferable for an electromagnetic wave transmission body, the Al*ₓ*Ga_{1-*x*}N single crystal of this embodying mode, although not particularly limited in this regard, has a span or diameter that is preferably 10 mm or greater and a thickness that is preferably 300 µm or greater. From the same standpoint, the span or diameter of the Al*ₓ*Ga_{1-*x*}N single crystal is preferably 50 mm or greater and more preferably 100 mm or greater. Also, the thickness of the Al*ₓ*Ga_{1-*x*}N single crystal is preferably 300 µm or greater, more preferably 1000 µm or greater, and yet more preferably 3000 µm or greater. In this case, the span of the Al*ₓ*Ga_{1-*x*}N single crystal, in the case in which a major surface thereof is polygonal, means the distance between two arbitrarily specified opposing vertices that surround a center part. Also, the diameter of the Al*ₓ*Ga_{1-*x*}N single crystal, in the case in which the major surface of the single crystal is circular or elliptical, means an arbitrarily specified diameter on the major surface.

Although the Al*ₓ*Ga_{1-*x*}N single crystal of this embodying mode is not limited in this regard, from the standpoint of increasing the planarity of the surface and making the mutual interaction between the Al*ₓ*Ga_{1-*x*}N single crystal and the plasma gas small, the RMS surface roughness is preferably 100 nm or lower, more preferably 10 nm or lower, and yet more preferably 1 nm or lower. The RMS surface roughness as the term is used herein is the root mean square roughness as set forth in JIS B 0601, which means the square root of the average value of the distance (variation) from an average surface to the measured surface.

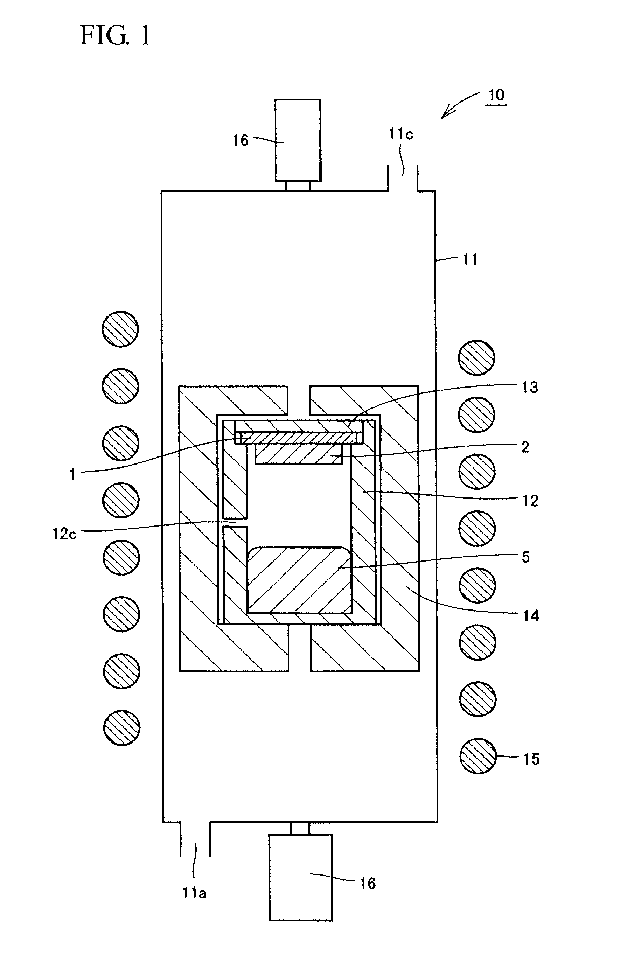

From the standpoint of facilitating the manufacture of an Al*ₓ*Ga_{1-*x*}N single crystal having both a low oxygen concentration and a low dislocation density, and that has a dielectric loss tangent of 5 × 10⁻³ or lower when at least either a 1-MHz RF signal or a 1-GHz RF signal is applied thereto at an atmospheric temperature of 25°C, although the method of manufacturing an Al*ₓ*Ga_{1-*x*}N single crystal of this embodying mode is not particularly limited in this regard, a preferable method is vapor-phase epitaxy, and sublimation growth (cf. Fig. 1) and HVPE (hydride vapor phase epitaxy) are particularly preferable.

From the standpoints noted above, the method of manufacturing the Al*ₓ*Ga_{1-*x*}N single crystal of this embodying mode preferably includes a step of preparing an underlying substrate 1, and a step of growing an Al*ₓ*Ga_{1-*x*}N single crystal 2 on the underlying substrate 1. In this case, the underlying substrate 1, from the standpoint of making the lattice mismatch between the Al*ₓ*Ga_{1-*x*}N single crystal and the underlying substrate small, an Al_{z}Ga_{1-z}N single crystal (0 < z < 1) is preferable and an Al*_{z}*Ga_{1-*z*}N single crystal in which z = *x* is more preferable. Also, from the standpoint of facilitating the growth of an Al*_{z}*Ga_{1-*z*}N single crystal having a low dislocation density and high crystallization, it is preferable that the Al*_{z}*Ga_{1-*z*}N single crystal, which is the underlying substrate 1, have a dislocation density of 1 ×10⁶ cm⁻² or lower, and more preferable that the full width at half-maximum of the x-ray diffraction peak for the (0002) plane be 100 arcsec or lower.

### Electromagnetic Wave Transmission Body

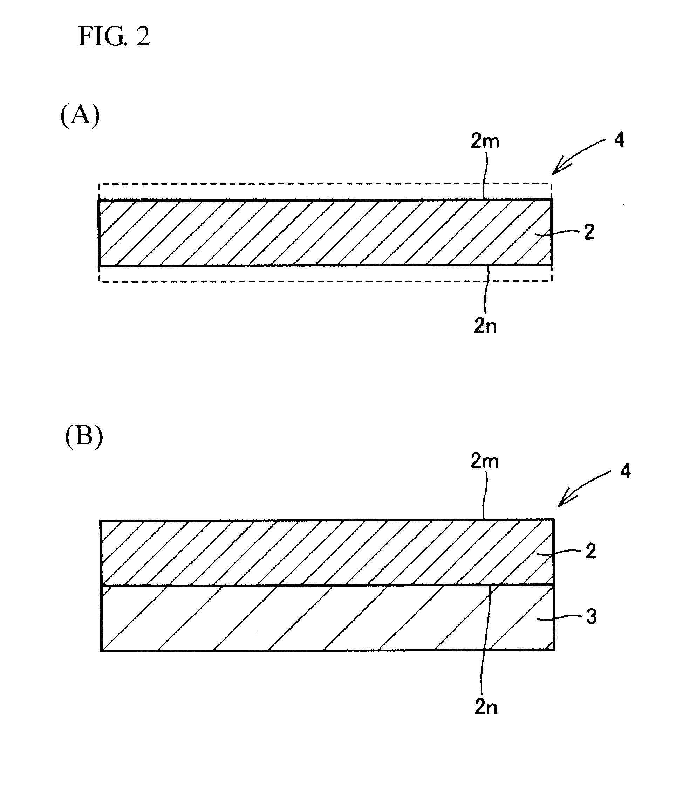

Referring to Fig. 2, the electromagnetic wave transmission body 4 of another embodying mode of the present invention includes an Al*ₓ*Ga_{1-*x*}N single crystal (0 < *x* ≤ 1) 2 having a 2*m* major surface, the Al*ₓ*Ga_{1-*x*}N single crystal 2 having a dielectric loss tangent of 5 × 10⁻³ or lower when at least either a 1-MHz or a 1-GHz RF signal is applied thereto at an atmospheric temperature of 25°C. For this reason, the electromagnetic wave transmission body of this embodying mode has an extremely small dielectric loss tangent, even when transmitting high-frequency electromagnetic radiation.

Also, the Al*ₓ*Ga_{1-*x*}N single crystal 2 that is included in the electromagnetic wave transmission body 4 of this embodying mode preferably has a dielectric loss tangent of 5 × 10⁻³ or lower when a 1-MHz RF signal is applied and also preferably has a dielectric loss tangent of 5 × 10⁻³ or lower when a 1-GHz RF signal is applied. The electromagnetic wave transmission body has an extremely small dielectric loss tangent even when transmitting electromagnetic radiation over a broad range of high frequencies spanning from on the order of MHz to on the order of GHz.

The electromagnetic wave transmission body 4 of this embodying mode includes an Al*ₓ*Ga_{1-*x*}N (0 < x ≤ 1) single crystal 2 having a 2*m* major surface. The Al*ₓ*Ga_{1-*x*}N single crystal 2, compared to an AIN sinter, has smaller local variation in the coefficient of thermal expansion. For this reason, even if the electromagnetic wave transmission body is exposed to a high-frequency plasma at the above-noted 2*m* main surface of the Al*ₓ*Ga_{1-*x*}N single crystal included therein, it tends not to be thermally stressed, and has a high resistance to heat shock.

It is sufficient that the electromagnetic wave transmission body 4 of this embodying mode include an Al*ₓ*Ga_{1-*x*}N single crystal having a major surface, and it is not necessary that, as shown in Fig. 2A, the entire electromagnetic wave transmission body be formed of the Al*ₓ*Ga_{1-*x*}N single crystal 2, it being possible as well, as shown in Fig. 2B, that a part of the electromagnetic wave transmission body 4 be formed of the AlₓGa₁₋ₓN single crystal 2. In the case, as shown in Fig. 2B, in which the electromagnetic wave transmission body 4 includes an Al*ₓ*Ga_{1-*x*}N single crystal 2 having a 2*m* major surface and an electromagnetic-radiation transmissive material 3 other than an Al*ₓ*Ga_{1*-x*}N single crystal, the electromagnetic-radiation transmissive material 3 is not particularly limited, as long as it does not hinder the transmission of electromagnetic radiation and can, for example, be quartz glass, alumina, or an AIN sinter or the like. In this case, the electromagnetic wave transmission body 4 is disposed so that the 2*m* major surface of the Al*ₓ*Ga_{1-*x*}N single crystal 2 is placed in a severe environment (for example, exposed to a plasma of a corrosive gas, or a high-power plasma).

Because the Al*ₓ*Ga_{1-*x*}N single crystal included in the electromagnetic wave transmission body 4 of this embodiment has a dielectric loss tangent of 5 × 10⁻³ or lower when a 1-MHz RF signal applied thereto at an atmospheric temperature of 25°C, the dielectric losses of the electromagnetic wave transmission body of this embodying mode are extremely low, even when high-frequency electromagnetic radiation is transmitted.

From the standpoint of making the oxygen concentration of the Al*ₓ*Ga_{1-*x*}N single crystal 2 included in the electromagnetic wave transmission body 4 of this embodying mode be small and suppressing the formation of the complex defect V_{Al}-O_{N} so as to make the dielectric loss tangent small, the oxygen concentration is preferably 1 × 10¹⁸ cm⁻³ or lower, more preferably 5 × 10¹⁷ cm⁻³ or lower, and yet more preferably 3 × 10¹⁷ cm⁻³ or lower.

Although the Al*ₓ*Ga_{1-*x*}N single crystal 2 included in the electromagnetic wave transmission body 4 of this embodying mode is not particularly limited in this regard, from the standpoint of reducing the dislocation density and suppressing the formation of the complex defect V_{Al}-O_{N} so as to make the dielectric loss tangent small, the dislocation density is preferably 1 × 10⁶ cm⁻² or lower, more preferably 5 × 10⁵ cm⁻² or lower, and yet more preferably 1 × 10⁵ cm⁻² or lower.

Also, from the standpoint of having a size that is preferable for use as an electromagnetic wave transmission body and mechanical strength, the electromagnetic wave transmission body 4 of this embodying mode, although not particularly limited in this regard, has a span or diameter that is preferably 50 mm or greater and a thickness that is preferably 300 µm or greater. From the same standpoint, the span or diameter is preferably 50 mm or greater and more preferably 100 mm or greater. Also, the thickness of the electromagnetic wave transmission body is preferably 300 µm or greater, more preferably 1000 µm or greater, and yet more preferably 3000 µm or greater. In this case, the span of the Al*ₓ*Ga_{1-*x*}N single crystal, in the case in which a major surface thereof is polygonal, means the distance between two arbitrarily specified opposing vertices that surround a center part. Also, the diameter of the Al*ₓ*Ga_{1-*x*}N single crystal, in the case in which the major surface of the single crystal is circular or elliptical, means an arbitrarily specified diameter on the major surface.

From the standpoint of making the interaction between the Al*ₓ*Ga_{1-*x*}N single crystal and the plasma gas small, although the electromagnetic wave transmission body of this embodying mode is not particularly limited in this regard, the RMS surface roughness is preferably 100 nm or less, more preferably 10 nm or less, and yet more preferably 1 nm or less.

From the standpoint of facilitating the manufacture of an Al*ₓ*Ga_{1-*x*}N single crystal having both a low oxygen concentration and a low dislocation density, and that has a dielectric loss tangent of 5 × 10⁻³ or lower when at least either a 1-MHz RF signal or a 1-GHz RF signal is applied thereto at an atmospheric temperature of 25°C, although the method of manufacturing the electromagnetic wave transmission body of this embodying mode is not particularly limited in this regard, a preferable method is a method of forming a desired shape from an Al*ₓ*Ga_{1-*x*}N single crystal grown by a vapor-phase epitaxy (sublimation growth and HVPE being particularly preferable) or a method of adhering another electromagnetic wave transmission body (for example, quartz glass, alumina, or an AIN sinter) to an Al*ₓ*Ga_{1-*x*}N single crystal processed to the desired shape.

As a method for forming a desired shape from an Al*ₓ*Ga_{1-*x*}N single crystal grown by vapor-phase epitaxy (and particularly by sublimation or HVPE), although there is no particular limitation in this regard, referring to Fig. 1 and Fig. 2A, one method is that the Al*ₓ*Ga_{1-*x*}N single crystal grown on the major surface underlying substrate 1 is sliced along a plane that is parallel to the major surface of the underlying substrate 1, and the sliced surface is planarized by grinding and/or polishing so as to form the major surfaces 2*m* and 2*n*. As a method of adhering another electromagnetic-radiation transmissive material to an Al*ₓ*Ga_{1-*x*}N single crystal formed to the desired shape, although there is no limitation in this regard, one method, referring to Fig. 2B, is that of adhering another electromagnetic-radiation transmissive material to one of the major surfaces, 2*n*, of the planarized Al*ₓ*Ga_{1-*x*}N single crystal 2 having 2*m* and 2*n* major surfaces. In this manner, an electromagnetic wave transmission body 4 that includes an Al*ₓ*Ga_{1-*x*}N single crystal 2 having a 2*m* major surface is obtained.

### Description of Embodiments

### Embodiment 1

### 1. Manufacture of an AIN Single Crystal

An AlN single crystal was grown as the Al*ₓ*Ga_{1-*x*}N single crystal 2 by the method of sublimation. In the growth of the AlN single crystal (Al*ₓ*Ga_{1-*x*}N single crystal 2) in this embodiment example, a vertical sublimation furnace 10 of the RF induction heating type, such as shown in Fig. 1, was used. A tungsten carbide crucible 12 having an exhaust port 12c was provided in the reaction vessel 11 in the vertical sublimation furnace 10, and a heating element 14 was provided that surrounded the crucible 12 to provide ventilation from the inside of the crucible to the outside. An RF induction heating coil 15 is provided at the center part outside the reaction vessel so as to heat the heating element 14 that heats the crucible 12. Additionally, an N₂ gas intake port 11a and an N₂ exhaust port 11c for the purpose of causing flow of N₂ gas, and a pyrometer 16 for measuring the temperatures of the upper surface and the lower surface of the crucible 12 are provided outside the crucible 12 of the reaction vessel 11, at the end part of the reaction vessel 11.

Referring to Fig. 1, as the Al*_{y}*Ga_{1-*y*}N (0 < *y* ≤1) source material 5, AIN powder was placed in the bottom part of the tungsten carbide crucible 12, and an AIN underlying substrate 1 having a diameter of 12 mm and a thickness of 1 mm was disposed at the top part of the crucible as the underlying substrate 1. The AlN underlying substrate 1 is formed of AIN single crystal, and had a dislocation density of 1 × 10⁶ cm⁻² or lower and a full width at half-maximum of the x-ray diffraction peak for the (0002) surface of 100 arcsec or smaller. The AlN underlying substrate 1 was held to the crucible lid 13, which was made of the same material as the crucible 12, so the AIN surface thereof opposes the Al*_{y}*Ga_{1-*y*}N source material 5.

Next, as N₂ gas was caused to flow into the reaction vessel 11, the RF induction heating coil 15 was used to raise the temperature within the crucible 12. The amounts of N₂ gas introduced and exhausted were controlled so that the partial pressure of the N₂ gas was 10 kPa to 100 kPa. During the temperature rise within the crucible 12, the temperature of the AIN underlying substrate 1 side of the crucible was made higher than the temperature of the Al*_{y}*Ga_{1-*y*}N source material 5 side, so that the surface of the AIN underlying substrate 1 was cleaned by etching, and impurities released from AIN underlying substrate 1 and the inner part of the crucible 12 were removed via the exhaust port 12c.

Next, after the temperature of the AIN powder (Al*_{y}*Ga_{1-*y*}N source material 5) side of the crucible 12 reached 2050°C, control was performed so that the N₂ partial pressure was 80 kPa, the temperature on the AIN powder (Al*_{y}*Ga_{1-*y*}N source material 5) side was 2350°C, and the temperature on the AlN underlying substrate 1 side was 1910°C, and the AIN was sublimated from the AIN power (Al*_{y}*Ga_{1-*y*}N source material 5), the AIN single crystal being re-solidified on top of the AIN underlying substrate 1 that had been placed at the upper part of the crucible 12 so as to grow the AIN single crystal (Al*ₓ*Ga_{1-*x*}N single crystal 2). Even during the growth of the AIN single crystal, N₂ gas continued to flow to the outside of the crucible 12 in the reaction vessel 11, and control was done so that the N₂ gas partial pressure outside the crucible 12 inside the reaction vessel 11 was 10 kPa to 100 kPa, by controlling the amount of N₂ gas introduced and the amount of N₂ gas exhausted. After growing an AIN single crystal (Al*ₓ*Ga_{1-*x*}N single crystal 2) on the AIN underlying substrate 1 for 40 hours under the above-noted conditions, cooling to room temperature (25°C) was done and an AIN single crystal was obtained. The AIN single crystal that was obtained had a diameter of approximately 12 mm and a thickness of approximately 4.2 mm, and was estimated to have been formed at a growth rate of 105 µm/hour.

### 2. Evaluation of the AIN Single Crystal

Referring to Fig. 1 and Fig. 2A, the obtained AIN single crystal (Al*ₓ*Ga_{1-*x*}N single crystal 2) was sliced along a plane parallel to the AIN single crystal growth plane so as to obtain several sheet-shaped AIN single crystals (Al*ₓ*Ga_{1-*x*}N single crystal 2) and sheet-shaped AIN single crystals adjacent to the above-noted AIN single crystals. The 2*m* and 2*n* major surfaces of each side of both AIN single crystals were ground and polished to planarize. The former was evaluated by applying to them an RF signal, and the latter was used in another evaluation. The RMS surface roughness of the 2*m* major surface of the sheet-shaped AIN single crystals was found to be a small value of 28 nm in a 50-µm square (square 50 µm × 50 µm) area, as measured by an AFM (atomic force microscope). In an embodying mode as an electromagnetic wave transmission body, the 2*m* major surface is placed in a severe environment (for example, exposed to a plasma of a corrosive gas or a high-power plasma). For this reason, it is preferable that the 2*m* major surface been highly resistance to chemical action, for example, making the Al-surface be the outside surface.

The sheet-shaped AIN single crystal at the uppermost part of the AIN single crystal has a small value of 35 arcsec for the full width at half-maximum of the x-ray diffraction peak for the (0002) plane, and was a crystal of high quality. Additionally, upon determining the dislocation density of the sheet-shaped AIN single crystal using the EPD (etch pit density) method, it was found to be a low value of 3 × 10⁴ cm⁻². The dislocation density was determined by the EPD method by etching the sheet-shaped AIN single crystal for 30 minutes at 250°C in a molten KOH : NaOH with a mass ratio of 1 : 1, and then using a microscope to determine the number of etch pits per unit surface area occurring in the major surface of the AIN single crystal.

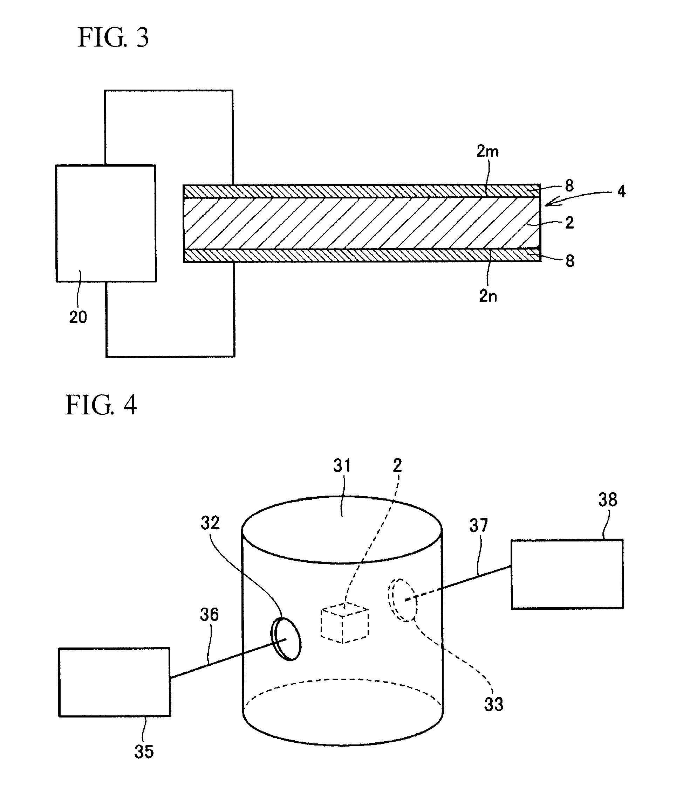

Referring to Fig. 3, an LCR meter 20 was used to measure the dielectric constant and the dielectric loss tangent of the AIN single crystal (Al*ₓ*Ga_{1-*x*}N single crystal 2) with a 1-MHz RF signal applied at an atmospheric temperature of 25°C. Specifically, Ti/Al/Ti/Au electrodes (with thicknesses of 20 nm/100 nm/20 nm/50 nm) were vapor deposited as electrodes 8 onto the 2m and 2n major surfaces on each side of the sheet-shaped AIN (Al*ₓ*Ga_{1-*x*}N single crystal 2), and placed in an infrared lamp heating oven and annealed for 1 minute at 600°C in an N₂ atmosphere to cause alloying of the electrodes 8. Next, using the LCR meter 20, the dielectric constant and dielectric loss tangent of the sheet-shaped AIN single crystal were measured at an atmospheric temperature of 25°C, with a 1-MHz AC signal applied across the electrodes 8 that were formed on the 2m and 2n major surfaces of the sheet-shaped AIN single crystal. The dielectric constant ε and the dielectric loss tangent tan δ were, respectively, 8.9 and 5.3 × 10⁻⁵.

Also, the oxygen concentration in the AIN single crystal, upon performing SIMS (secondary ion mass spectrometry) using a sample of 5 mm square cut away from the center of another sheet-shaped AIN single crystal, was a low value of 5.2 × 10¹⁷ cm⁻³.

### Embodiment 2

With the exception of using N₂ gas at a partial pressure of 50 kPa and making the temperature of the AIN powder (Al*_{y}*Ga_{1-*y*}N source material 5) side be 2300°C, an AIN single crystal (Al*ₓ*Ga_{1-*x*}N single crystal 2) was grown in the same way as in Embodiment 1.
The AIN single crystal that was obtained had a thickness of 5.2 mm, a growth rate of 130 µm/hour, a full width at half-maximum of the x-ray diffraction peak for the (0002) plane of 42 arcsec, a dislocation density of 4.0 × 10⁴ cm⁻² , an RMS surface roughness of 43 nm, a dielectric constant ε of 8.7 and dielectric loss tangent tan δ of 7.2 × 10⁻⁵ with a 1-MHz RF signal applied at an atmospheric temperature of 25°C, and an oxygen concentration of 4.7 × 10¹⁷ cm⁻³. The results are summarized in Table I.

### Embodiment 3

With the exception of using N₂ gas at a partial pressure of 10 kPa and making the temperature of the AIN powder (Al*_{y}*Ga_{1-*y*}N source material 5) side be 2250°C, an AIN single crystal (Al*ₓ*Ga_{1-*x*}N single crystal 2) was grown in the same way as in Embodiment 1. The AIN single crystal that was obtained had a thickness of 5.8 mm, a growth rate of 145 µm/hour, a full width at half-maximum of the x-ray diffraction peak for the (0002) plane of 72 arcsec, a dislocation density of 9.0 × 10⁴ cm⁻², an RMS surface roughness of 28 nm, a dielectric constant ε of 8.7 and dielectric loss tangent tan δ of 2.8 × 10⁻⁴with a 1-MHz RF signal applied at an atmospheric temperature of 25°C, and an oxygen concentration of 5.1 × 10¹⁷ cm⁻³. The results are summarized in Table I.

### Embodiment 4

A 50.8-mm (2-inch) diameter SiC underlying substrate was used as the underlying substrate 1 and, with the exception of using N₂ gas at a partial pressure of 50 kPa and making the temperature of the SiC underlying substrate 1 side be 1730°C, and making the temperature of the AIN powder (Al*_{y}*Ga_{1-*y*}N source material 5) side be 2050°C, an AIN single crystal (Al*ₓ*Ga_{1-*x*}N single crystal 2) was grown in the same way as in Embodiment 1.
The AIN single crystal that was obtained had a thickness of 4.3 mm, a growth rate of 107.5 µm/hour, a full width at half-maximum of the x-ray diffraction peak for the (0002) plane of 115 arcsec, a dislocation density of 5.6 × 10⁵ cm⁻² , an RMS surface roughness of 40 nm, a dielectric constant ε of 8.6 and dielectric loss tangent tan δ of 1.6 × 10⁻³ with a 1-MHz RF signal having been applied to the crystal at an atmospheric temperature of 25°C, and an oxygen concentration of 1.4 × 10¹⁸ cm⁻³.

Referring to Fig. 4, the cavity resonator method was used to measure the dielectric constant and the dielectric loss tangent of the AIN single crystal (AlₓGa_{1-X}N single crystal 2) with a 1-GHz RF signal applied, at an atmospheric temperature of 25°C. In the cavity resonator method, the measurement system shown in Fig. 4 was used. Specifically, a columnar shaped cavity resonator 31 is formed of a good conductor, such as copper or aluminum, and the inside thereof is hollow. This hollow space is used as a resonance field for electromagnetic radiation. The cavity resonator 31 has an input signal aperture 32 for the input of an electromagnetic RF signal to excite the resonator, and a signal detection output aperture 33 for measuring the resonance condition. An RF signal caused by electromagnetic radiation generated by an RF signal generator 35 is, for example, input to the cavity resonator 31 from the aperture 32 via a signal line 36. By doing this, an electromagnetic field resonance condition of a prescribed mode is caused inside the cavity resonator 31. A signal that indicates the resonance condition is extracted from the aperture 33 via a signal line 37, and sent to a resonance condition analyzer 38, such as a spectrum analyzer. The resonance condition analyzer 38 measures the resonance condition from the detected signal and, from the measurement results, makes it possible to determine factors characterizing the dielectric properties of the AIN single crystal that is the object under measurement.

Specifically, in the above-noted measurement system, detection is made of the change in the resonance condition between the condition in which a 1 mm × 1 mm × 30 mm AIN crystal (Al*ₓ*Ga_{1-*x*}N single crystal 2) sample cut from another sheet-shaped AIN single crystal is placed in the cavity resonator and the condition in which it is removed therefrom, and a calculation is performed on the change in resonance condition, so as to determine the dielectric constant ε and the dielectric loss tangent tan δ of the AIN single crystal. The dielectric constant ε and the dielectric loss tangent tan δ obtained in this manner for AIN single crystal to which a 1-GHz RF signal was applied at an atmospheric temperature of 25°C were, respectively, 8.5 and 1.9 × 10⁻³. The results are summarized in Table I.

### Embodiment 5

A 50.8-mm (2-inch) diameter AIN underlying substrate was used as the underlying substrate 1 and, with the exception of using N₂ gas at a partial pressure of 50 kPa and making the temperature of the AIN underlying substrate 1 side be 1930°C, and making the temperature of the AIN powder (Al*_{y}*Ga_{1-*y*}N source material 5) side be 2310°C, an AIN single crystal (Al*ₓ*Ga_{1-*x*}N single crystal 2) was grown in the same way as in Embodiment 1. The AIN single crystal that was obtained had a thickness of 3.2 mm, a growth rate of 80 µm/hour, a full width at half-maximum of the x-ray diffraction peak for the (0002) plane of 86 arcsec, a dislocation density of 1.3 × 10⁵ cm⁻² , an RMS surface roughness of 35 nm, a dielectric constant ε of 8.8 and dielectric loss tangent tan δ of 6.2 × 10⁻⁴ with a 1-MHz RF signal applied at an atmospheric temperature of 25°C, a dielectric constant ε of 8.7 and dielectric loss tangent tan δ of 6.5 × 10⁻⁴ with a 1-GHz RF signal applied at an atmospheric temperature of 25°C, and an oxygen concentration of 5.8 × 10¹⁷ cm⁻³ . The results are summarized in Table I.

**Table I.**

| | | | Embodiment 1 | Embodiment 2 | Embodiment 3 | Embodiment 4 | Embodiment 5 |
|---|---|---|---|---|---|---|---|
| Al*ₓ*Ga_{1*-x*}N Crystal growth conditions | Underlying substrate | Chemical composition | AIN | AIN | AIN | SiC | AlN |
| | | Diameter (mm) | 12 | 12 | 12 | 50.8 | 50.8 |
| | Al*_{y}*Ga_{1-*y*}N source material | | AIN | AIN | AIN | AIN | AIN |
| | N₂ gas partial pressure (kPa) | | 80 | 50 | 10 | 50 | 50 |
| | Underlying substrate side temperature (°C) | | 1910 | 1910 | 1910 | 1730 | 1930 |
| | Al*_{y}*Ga_{1-*y*}N source material side temperature (°C) | | 2350 | 2300 | 2250 | 2050 | 2310 |
| | Al*ₓ*Ga_{1-*x*}N crystal | | AIN | AIN | AIN | AIN | AIN |
| | Crystal growth time (hr) | | 40 | 40 | 40 | 40 | 40 |
| Al*ₓ*Ga_{1-*x*}N Crystal characteristics | Crystal growth thickness (mm) | | 4.2 | 5.2 | 5.8 | 4.3 | 3.2 |
| | Crystal growth rate (µm/hr) | | 105 | 130 | 145 | 107.5 | 80 |
| | x-ray diffraction peak full width at half-max. (arcsec) | | 35 | 42 | 72 | 115 | 86 |
| | Dislocation density (cm⁻²) | | 3.0× 10⁴ | 4.0× 10⁴ | 9.0×10⁴ | 5.6×10⁵ | 1.3×10⁵ |
| | RMS surface roughness (nm) | | 28 | 43 | 28 | 40 | 35 |
| | 1 MHz | Dielectric constant ε | 8.9 | 8.7 | 8.7 | 8.6 | 8.8 |
| | | Dielectric loss tangent tan δ | 5.3×10⁻⁵ | 7.2×10⁻⁵ | 2.8×10⁻⁴ | 1.6×10⁻³ | 6.2×10⁻⁴ |
| | 1 GHz | Dielectric constant ε | - | - | - | 8.5 | 8.7 |
| | | Dielectric loss tangent tan δ | - | - | - | 1.9×10⁻³ | 6.5 ×10⁻⁴ |
| | Oxygen concentration (cm⁻³) | | 5.2×10¹⁷ | 4.7×10¹⁷ | 5.1×10¹⁷ | 1.4×10¹⁸ | 5.8×10¹⁷ |

As is clear from Table I, by reducing the oxygen concentration and the dislocation density (preferably to an oxygen concentration of 1 × 10¹⁸ cm⁻³ or lower and a dislocation density of 1 × 10⁶ cm⁻² or lower), an Al*ₓ*Ga_{1-*x*}N single crystal is obtained that has a dielectric loss tangent of 5 × 10⁻³ or lower with a 1-MHz RF signal applied at an atmospheric temperature of 25°C and/or a dielectric loss tangent of 5 × 10⁻³ or lower with a 1-GHz RF signal applied at an atmospheric temperature of 25°C.

The presently disclosed embodying modes and embodiment examples should in all respects be considered to be illustrative and not limiting. The scope of the present invention is set forth not by the foregoing description but by the scope of the claims, and is intended to include meanings equivalent to the scope of the claims and all modifications within the scope.

### Reference Signs List

- 1:: underlying substrate
- 2:: Al*ₓ*Ga_{1-*x*}N single crystal
- 2*m,* 2*n:*: major surfaces
- 3:: other electromagnetic-radiation transmissive material
- 4:: electromagnetic wave transmission body
- 5:: Al*_{y}*Ga_{1-*y*}N source material
- 8:: electrode
- 10:: sublimation furnace
- 11:: reaction vessel
- 11 a:: N₂ gas intake port
- 11 c:: N₂ gas exhaust port
- 12:: crucible
- 12c:: exhaust port
- 13:: crucible lid
- 14:: heating element
- 15:: RF induction heating coil
- 16:: pyrometer
- 20:: LCR meter
- 31:: cavity resonator
- 32, 33:: apertures
- 35:: RF signal generator
- 36, 37:: signal lines
- 38:: resonance condition analyzer

## Claims

1. An Al*ₓ*Ga_{1-*x*}N (0 < x ≤1) single crystal having a dielectric loss tangent of 5 × 10⁻³ or lower with a radio-frequency signal of at least either 1 MHz or 1 GHz having been applied thereto at an atmospheric temperature of 25°C.

2. An Al*ₓ*Ga_{1-*x*}N single crystal as set forth in claim 1, wherein the dielectric loss tangent is 5 × 10⁻³ or lower with a 1-MHz radio-frequency signal having been applied thereto, and also the dielectric loss tangent is 5 × 10⁻³ or lower with a 1-GHz radio-frequency signal having been applied thereto.

3. An Al*ₓ*Ga_{1-*x*}N single crystal as set forth in either claim 1 or claim 2, wherein the oxygen concentration is 1 × 10¹⁸ cm⁻³ or lower.

4. An Al*ₓ*Ga_{1-*x*}N single crystal as set forth in either claim 1 or claim 2, wherein the dislocation density is 1 × 10⁶ cm⁻² or lower.

5. An Al*ₓ*Ga_{1-*x*}N single crystal as set forth in any one of claim 1 to claim 4, wherein:
the span or the diameter is 10 mm or greater; and
the thickness is 300 µm or greater.

6. An Al*ₓ*Ga_{1-*x*}N single crystal as set forth in any one of claim 1 to claim 5, wherein the RMS surface roughness is 100 nm or less.

7. An electromagnetic wave transmission body including an Al*ₓ*Ga_{1-*x*}N (0 < x ≤1) single crystal having a major surface, wherein the Al*ₓ*Ga_{1-*x*}N single crystal has a dielectric loss tangent of 5 × 10⁻³ or lower with a radio-frequency signal of at least either 1 MHz or 1 GHz having been applied thereto at an atmospheric temperature of 25°C.

8. An electromagnetic wave transmission body as set forth in claim 7, wherein the Al*ₓ*Ga_{1-*x*}N single crystal has a dielectric loss tangent of 5 × 10⁻³ or lower with a 1-MHz radio-frequency signal having been applied thereto, and also has a dielectric loss tangent of 5 × 10⁻³ or lower with a 1-GHz radio-frequency signal having been applied thereto.

9. An electromagnetic wave transmission body as set forth in either claim 7 or claim 8, wherein the oxygen concentration of the Al*ₓ*Ga_{1-*x*}N single crystal is 1 × 10¹⁸ cm⁻³ or lower.

10. An electromagnetic wave transmission body as set forth in either claim 7 or claim 8, wherein the Al*ₓ*Ga_{1-*x*}N single crystal has a dislocation density of 1 × 10⁶ cm⁻² or lower.

11. An electromagnetic wave transmission body as set forth in any one of claim 7 to claim 10, wherein:
the span or the diameter is 10 mm or greater; and
the thickness is 300 µm or greater.

12. An electromagnetic wave transmission body as set forth in any one of claim 7 to claim 11, wherein the RMS surface roughness is 100 nm or less.
